# EUROPEAN PATENT APPLICATION

(11) **EP 4 391 084 A1**
(43) Date of publication of application: **26.06.2024**
(21) Application number: 22871408.5
(22) Date of filing: 11.05.2022
(51) Int. Cl.: H01L 31/0288, H01L 31/0216

(54) **BACK-CONTACT CELL AND MANUFACTURING METHOD THEREFOR**

(30) Priority: 22.09.2021 CN 202111118365
(71) Applicant: Longi Solar Technology (Taizhou) Co., Ltd., Taizhou, Jiangsu 225300 (CN)
(72) Inventor: LI, Zhonglan, Taizhou, Jiangsu 225300 (CN); LU, Weiming, Taizhou, Jiangsu 225300 (CN); LI, Hua, Taizhou, Jiangsu 225300 (CN); JIN, Yupeng, Taizhou, Jiangsu 225300 (CN)
(74) Representative: Loo, Chi Ching
(86) International application number: PCT/CN2022/092272
(87) International publication number: WO 2023/045347

(57) **Abstract**

This application discloses a back contact solar cell and method for manufacturing the same, which relates to the field of photovoltaic technology and is used to simplify the manufacturing process of back contact solar cell while ensuring high photovoltaic conversion efficiency. The back contact solar cell comprises: a substrate having opposing first and second surfaces, with the first surface having staggered first doped regions and second doped regions, and a third region between the first doped region and the second doped region. The back contact solar cell further includes a first doped layer and a second doped layer formed on the first doped region, with the first doped layer having a conductivity type opposite to that of the second doped layer; a third doped layer formed on the second doped region and having a conductivity type opposite to that of the first doped layer; and first and second electrodes, with the first electrode electrically contacting the second doped layer and the second electrode electrically contacting the third doped layer. The method for manufacturing the back contact solar cell provided in the application is used to manufacture the back contact solar cell.

## Description

### CROSS-REFERENCE TO RELATED APPLICATIONS

The present disclosure claims the priority of the Chinese patent application filed on September 22nd, 2021 before the China National Intellectual Property Administration with the application number of 202111118365.0 and the title of "BACK CONTACT SOLAR CELL AND METHOD FOR MANUFACTURING THE SAME", which is incorporated herein in its entirety by reference.

### TECHNICAL FIELD

The present disclosure relates to the technology field of photovoltaics and, more particularly, to a back contact solar cell and method for manufacturing the same.

### BACKGROUND

A back contact solar cell refers to a solar cell that an emitter and a metal contact are located on the back of the cell, and there are not metal electrodes shielding the front. Comparing with the solar cell with the front being shielded, the back contact solar cell has higher short-circuit current and photoelectric conversion efficiency, and is one of the technical directions to achieve high-efficiency crystalline silicon solar cells.

Since the method for manufacturing the back contact solar cell is complex, there is needed to provide a method for manufacturing the solar cell with easy process and high efficiency.

### SUMMARY

It is an object of the present disclosure to provide a back contact solar cell and the manufacturing method thereof, to simplify the manufacturing process of the back contact solar cell under the situation of ensuring high photovoltaic conversion efficiency.

In a first aspect, the present disclosure discloses a back contact solar cell, including:
a substrate comprising a first surface and a second surface opposite to each other, wherein the first surface comprises a first doped region, a second doped region and a third region, the first doped region and the second doped region are arranged in a staggered manner, and the third region is located between the first doped region and the second doped region;
a first doped layer and a second doped layer sequentially formed on the first doped region, wherein a conductivity type of the first doped layer is opposite to a conductivity type of the second doped layer;
a third doped layer formed on the second doped region, wherein a conductivity type of the third doped layer is opposite to the conductivity type of the first doped layer; and
a first electrode and a second electrode, wherein the first electrode is electrically contacted with the second doped layer, and the second electrode is electrically contacted with the third doped layer.

In the case of adopting the aforementioned technical solution, the first surface of the substrate has a first doped region, where the first doped region comprises sequentially formed first doped layer and second doped layer with opposite conductive types. Accordingly, the second doped layer covers the first doped layer, protecting the surface of the first doped layer and preventing it from being damaged or contaminated during subsequent process steps, thereby enhancing the yield and production efficiency of back contact solar cells. Furthermore, the second doped layer and the third doped layer can be formed in the same process step, saving one process step, reducing labor hours, and improving the production capacity and efficiency during mass production.

In some possible implementations, along a staggering direction of the first doped region and the second doped region, a width of the third region is 10µm~100µm; and/or a surface of the third region has a velvety structure. No electrodes are arranged on the third region, allowing for texturing treatment on the third region to impart a textured surface. The textured surface on the third region enhances light trapping and anti-reflection effects, enabling the utilization of incident light on the first surface. This increases light absorption on the first surface of the back contact solar cell, enabling it to absorb light energy from both sides and further enhance light utilization, thereby improving the power generation efficiency of the back contact solar cell.

In some possible implementations, a surface of the first doped region and/or a surface of the second doped region is a polished surface. In the case of employing the aforementioned technical solution, both the surfaces of the first doped region and the second doped region can be polished, allowing light entering from the second surface and passing through the back contact solar cell to undergo reflection, thereby providing an opportunity for the light to be reused by the back contact solar cell, thus enhancing the photovoltaic conversion efficiency of the back contact solar cell. Additionally, the polished surfaces exhibit improved smoothness, which facilitates better formation of other layers on the polished surface in subsequent processes, thereby reducing the generation of interface defects and subsequently decreasing carrier recombination caused by defects. This is conducive to enhancing the passivation performance of the back contact solar cell, thereby improving its photovoltaic conversion efficiency.

In some possible implementations, the second doped layer is a hydrogen-doped layer. At this point, the second doped layer located on the first doped layer not only protects the integrity of the first doped layer during subsequent patterning processes but also provides additional hydrogen to passivate dangling bonds within the first doped layer, reducing carrier recombination and thereby enhancing the photovoltaic conversion efficiency of the solar cell.

In some possible implementations, the first doped layer is a doped polycrystalline silicon layer, and the second doped layer and the third doped layer are doped polycrystalline silicon layers or doped amorphous silicon layers; or the first doped layer is a doped polycrystalline silicon layer, the second doped layer is a hydrogen-doped polycrystalline silicon layer or a hydrogen-doped amorphous silicon layer, and the third doped layer is a doped polycrystalline silicon layer or a doped amorphous silicon layer; or the first doped layer is a doped polycrystalline silicon layer, the second doped layer is a hydrogen-doped doped silicon carbide layer, and the third doped layer is a doped polycrystalline silicon layer or a doped amorphous silicon layer. The second doped layer and the third doped layer can be formed either in the same processing step or in separate processing steps. Silicon carbide itself possesses characteristics such as wide bandgap, high breakdown field, and high thermal conductivity, along with excellent nonlinear conductive properties. Additionally, hydrogen present in hydrogenated silicon carbide layers, hydrogen-doped polycrystalline silicon layers, or hydrogen-doped amorphous silicon layers can provide additional passivation effects, thereby beneficially enhancing the photovoltaic conversion efficiency of back contact solar cells.

In some possible implementations, the back contact solar cell further comprises a first interface passivation layer, a second interface passivation layer and a third interface passivation layer, wherein the first interface passivation layer is located between the substrate and the first doped layer, the second interface passivation layer is located between the first doped layer and the second doped layer, and the third interface passivation layer is located between the substrate and the third doped layer. The first interface passivation layer, the second interface passivation layer, and the third interface passivation layer respectively passivate the interfaces between the substrate and the first doped layer, reducing carrier recombination at the interfaces, thus ensuring efficient carrier transport.

In some possible implementations, the substrate is an n-type substrate, the first doped layer is a p-type doped layer, and the second doped layer and the third doped layer are n-type doped layers; or, the substrate is a p-type substrate, the first doped layer is an n-type doped layer, and the second doped layer and the third doped layer are p-type doped layers. When the substrate is of n-type, the first doped layer is of p-type doping, and both the second and third doped layers can be phosphorus-doped n-type doped layers. In this case, since regions heavily doped with phosphorus have a greater solubility for metal impurities, the phosphorus present in the second doped layer can act as a phosphorus getter to passivate the first doped layer, thereby enhancing the efficiency of the solar cell.

In some possible implementations, along a staggering direction of the first doped region and the second doped region, a width of the first doped region is greater than a width of the second doped region, the width of the first doped region is 600µm~2000µm, and the width of the second doped region is 200µm~1000µm. Based on this, the width of the first doped layer on the first doped region is greater than the width of the third doped layer on the second doped region, resulting in a wider range of widths for the formed pn junction. This wider range of widths leads to a larger area for carrier separation, facilitating the separation of carriers and thereby enhancing the photovoltaic conversion efficiency of the solar cell.

In some possible implementations, the back contact solar cell further comprises a first surface passivation layer, wherein the first surface passivation layer covers the second doped layer, the third doped layer, and the third region; the first surface passivation layer has a first opening at a contact surface with the second doped layer, the first electrode is electrically contacted with the second doped layer via the first opening; the first surface passivation layer has a second opening at the contact surface with the third doped layer, the second electrode is electrically contacted with the third doped layer via the second opening.

In the case of employing the aforementioned technical solution, a first surface passivation layer is formed on the outer side of the second doped layer, the third doped layer, and the third region. The first surface passivation layer can passivate the surface of the back contact solar cell, passivating dangling bonds at the second doped layer, the third doped layer, and the third region, reducing carrier recombination velocity at the first surface, thus enhancing the photovoltaic conversion efficiency. The first electrode and the second electrode make contact with the second doped layer and the third doped layer, respectively, through the first opening and the second opening, forming local ohmic contacts between metal and semiconductor. This reduces the contact area between the metal electrode and the second doped layer and the third doped layer, lowering the contact resistance and further reducing the recombination rate of carriers at the electrode surface, thereby increasing the open-circuit voltage.

In some potential implementations, the second surface possesses a textured structure. Additionally, the second surface features a second surface passivation layer. The textured structure on the second surface exhibits excellent light-trapping effects, reducing the reflection of incident light on the second surface and thereby increasing light utilization efficiency. The second surface passivation layer serves to passivate the substrate interface on the second surface, reducing carrier recombination at the interface and enhancing carrier transport efficiency. Consequently, this improves the photovoltaic conversion efficiency of the back contact solar cell.

A second aspect of the present application discloses a method for manufacturing the back contact solar cell according to any one of claims 1 to 9, wherein the method includes:
providing the substrate having the first surface and the second surface opposite to each other, wherein the first surface has the first doped region, the second doped region and the third region, the first doped region and the second doped region are arranged in the staggered manner, and the third region is located between the first doped region and the second doped region;
forming the first doped layer on the first surface of the substrate;
removing the first doped layer located on the second doped region and the third region;
forming the doped film layer on the first doped layer and the first surface;
removing the doped film layer on the third region, to regard the doped film layer on the first doped layer as the second doped layer, and the doped film layer on the first surface as the third doped layer;
forming the first electrode on the second doped layer, and forming the second electrode on the third doped layer.

The beneficial effects of the manufacturing method for back contact solar cell provided by either the second aspect or any possible implementation thereof can be referred to the beneficial effects described for back contact solar cell in the first aspect or any possible implementation thereof, without further elaboration here.

In some possible implementations, the step of removing the first doped layer located on the second doped region and the third region includes: forming a first protecting layer on the first doped layer in the first doped region; removing the first doped layer on the second doped region and the third region; removing the first protecting layer; and/or,
the step of removing the doped film layer on the third region includes: forming a second protecting layer on the doped film layer of the first doped region and the second doped region; removing the doped film layer on the third region; and removing the second protecting layer.

In some possible implementations, the first protecting layer and the second protecting layer comprise at least one of a dielectric layer and a mask layer.

In some possible implementations, a method for forming the first doped layer and the doped film layer is an in-situ doping method or a non-in-situ doping method.

In some possible implementations, before forming the first doped layer on the first surface of the substrate, the method further comprises: forming a first interface passivation layer on the first surface of the substrate; in the step of removing the first doped layer of the second doped region and the third region, the method further comprises: removing the first interface passivation layer of the second doped region and the third region; and/or,
after removing the first interface passivation layer and the first doped layer of the second doped region and the third region, and before forming the doped film layer on the first doped layer and the first surface, the method further comprises: forming an interface passivation film layer on the first doped layer and the first surface;
in the step of removing the doped film layer on the third region, the method further comprises: removing the interface passivation film layer on the third region, to regard the interface passivation film layer on the first doped layer as the second interface passivation layer, and regard the interface passivation film layer on the first surface as the third interface passivation layer.

In some possible implementations, after removing the doped film layer on the third region, the method further includes: texturing the third region.

In some possible implementations, the step of forming the first electrode on the second doped layer and forming the second electrode on the third doped layer comprises: forming a first surface passivation layer on the second doped layer, the third doped layer, and the third region; forming the first electrode on the first surface passivation layer located at the second doped layer, and forming the second electrode on the first surface passivation layer located at the third doped layer, wherein the first electrode is electrically contacted with the second doped layer, and the second electrode is electrically contacted with the third doped layer.

In some possible implementations, before forming the first surface passivation layer on the second doped layer, the third doped layer, and the third region, the method further comprises: conducting a heat treatment process, wherein the heat treatment process crystallizes at least a portion of the first doped layer and/or the second doped layer and/or the third doped layer.

In some possible implementations, the method further includes: performing texture treatment to the second surface, and forming a second surface passivation layer on the second surface.

### BRIEF DESCRIPTION OF THE DRAWINGS

The accompanying drawings, which are included to provide a further understanding of the present disclosure and are incorporated in and constitute a part of the present disclosure. Illustrative embodiments of the present disclosure and together with the description serve to explain the present disclosure and do not constitute an undue limitation of the present disclosure. In the drawings,
FIG. 1 is a schematic diagram of the structure of the back contact solar cell provided in the present embodiment of the application;
FIG. 2 to 9 are schematic diagrams of the various stages of the production process of the back contact solar cell provided in the present embodiment of the application;
FIG. 10 is a schematic diagram of the first surface of the back contact solar cell provided in the present embodiment of the application;
FIG. 11 is a schematic diagram of the first surface of the back contact solar cell provided in the present embodiment of the application, with continuous contact electrodes;
FIG. 12 is a partial schematic diagram of the first surface of the back contact solar cell provided in the present embodiment of the application, with localized contact electrodes.

### Elements and reference numbers:

10-substrate, 101-first doped region,
102-second doped region, 103-third region,
11-first doped layer, 12-doped film layer
121-second doped layer, 122-third doped layer
13-first surface passivation layer; 130 first opening
131-second opening, 14- first interface passivation layer
15-interface passivation film layer; 151-second interface passivation layer
152-third interface passivation layer; 16-first protecting layer
17-second protecting layer; 20-first electrode
21-second electrode; 201-first electrode main electrode
202-first electrode sub-gate line, 211-second electrode main electrode
212 second electrode sub-gate line, 203-connecting electrode
204-fine gate line, 18-second surface passivation layer
205 local contact point

### DETAILED DESCRIP TION OF THE EMBODIMENTS

In order to make the technical problems to be solved, the technical solutions, and beneficial effects of the present disclosure clearer, the following further describes some embodiments of the present disclosure in detail with reference to the accompanying drawings and embodiments. It should be understood that the specific embodiments described herein are merely illustrative of the present disclosure and are not intended to limit the present disclosure.

It should be noted that when an element is called to be "fixed on" or "arranged on" another element, it may be directly arranged on another element or indirectly arranged on another element. When an element is called to be "connected" to another element, it may be directly connected to another element or indirectly connected to another element.

Moreover, the terms "first" and "second" are only used for descriptive purposes, but cannot be understood as indicating or implying relative importance, or implicitly indicating the number of indicated technical features. Therefore, the features defined with "first" and "second" can explicitly or implicitly include one or more of the features. In the description of the present disclosure, the meaning of "a plurality of" is two or more than two, unless otherwise specifically defined. The meaning of "several" is one or more, unless otherwise specifically defined.

In the description of the present disclosure, it should be understood that the orientation or position relationship indicated by such terms as "upper", "lower", "front", "rear", "left", "right", or the like, is based on the orientation or position relationship shown in the drawings, which is only used for convenience of description of the present disclosure and simplification of description instead of indicating or implying that the indicated device or element must have a specific orientation, and be constructed and operated in a specific orientation, and thus shall not be understood as a limitation to the present disclosure.

In the description of the present disclosure, it should be noted that unless expressly stipulated and defined otherwise, terms such as "installation", "connected" and "connection", or the like, should be understood broadly, for example, the connection may be fixed connection, or detachable connection or integral connection; may be mechanical connection, and may also be electrical connection; and may be direct connection, may also be indirect connection through an intermediate medium, and may also be internal communication of two elements or interaction relationship of two elements. The specific meaning of the above terms in the present disclosure may be understood in a specific case by those having ordinary skills in the art.

As a new energy alternative solution, solar cells are more and more widely used at present. The solar cell is a device that converts the light energy of the sun into electrical energy. Based on the photovoltaic principle, solar cells generate carriers, and then use the electrode to extract the carriers, which is conducive to the effective use of electrical energy.

Finger-shaped cross back contact solar cell is also known as IBC solar cell. IBC refers to the interdigitated back contact. The biggest feature of the IBC solar cell is that the emitter and the metal contact are on the back of the solar cell, and there are not effect of metal electrode shielding on the front, therefore the IBC solar cell has a higher short-circuit current Isc, and at the same time, a wider metal gate line may be allowed on the back to reduce the series resistance Rs, thus the fill factor FF is increased. This solar cell with the front being not shielded not only has a high conversion efficiency, but also looks more beautiful, and at the same time, the components of the full-back electrode are easier to be assembled. At present, the IBC solar cell is one of the technical directions to achieve high-efficiency crystalline silicon solar cells.

However, the cell efficiency of the current IBC solar cells is uneven and the yield is not high. In addition, since the electrodes of the IBC solar cell structure are all on the back, problems such as electric leakage and the like easily occur in the electrical structure, resulting in low power conversion efficiency of the solar cell.

In order to solve the above technical problem, a back contact solar cell is provided by embodiments of the present disclosure for solving the problem of electric leakage of the back contact solar cell and improving the power conversion efficiency of the back contact solar cell.

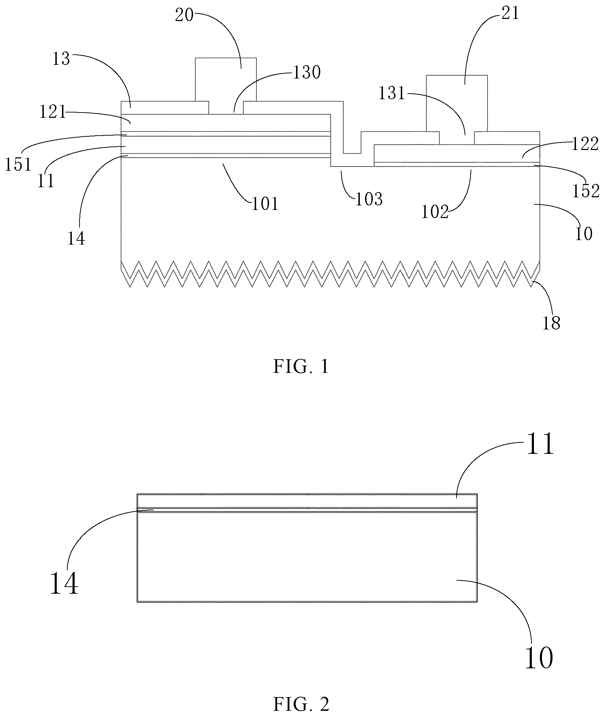

As shown in FIG. 1, a back contact solar cell provided in the embodiment of the present application includes: a substrate 10, which has a first surface and a second surface disposed opposite to each other. The first surface has a first doped region 101, a second doped region 102 and a third region 103, the first doped region 101 and the second doped region 102 are arranged in a staggered manner, and the third region 103 is located between the first doped region 101 and the second doped region 102. The third region 103 is used to separate the first doped region 101 and the second doped region 102. The back contact solar cell further includes a first doped layer 11 and a second doped layer 121 successively formed on the first doped region 101. The conductivity type of the first doped layer 11 is opposite to that of the second doped layer 121. A third doped layer 122 is formed on the second doped region 102. The conductivity type of the third doped layer 122 is opposite to that of the first doped layer 11. Additionally, the back contact solar cell further includes a first electrode 20 and a second electrode 21. The first electrode 20 is electrically in contact with the second doped layer 121, and the second electrode 21 is electrically in contact with the third doped layer 122.

From the structure of the back contact solar cell described above, it may be seen that the first surface of the substrate 10 has the first doped region 101, on which the first doped layer 11 and the second doped layer 121 are successively formed. The conductivity types of the first doped layer 11 and the second doped layer 121 are opposite. Based on this, the second doped layer 121 covers the first doped layer 11, this may protect the surface of the first doped layer 11 and avoid damage the first doped layer 11, or introducing impurities to the first doped layer 11 in subsequent process steps, thereby improving the yield and production efficiency of the back contact solar cell. At the same time, it significantly reduces the open film area and difficulty in patterning the first doped layer 11, thereby increasing the production capacity and reducing costs.

The substrate 10 is a semiconductor substrate 10. The material of the substrate 10 may be selected from materials such as silicon (Si) or germanium (Ge), or materials such as gallium arsenide (GaAs). In terms of conductivity type, the substrate 10 may be an intrinsic conductivity substrate 10, an n-type conductivity substrate 10, or a p-type conductivity substrate 10. Preferably, the substrate 10 is a p-type conductivity substrate 10 or an n-type conductivity substrate 10. Compared with the intrinsic conductivity substrate 10, the p-type conductivity substrate 10 or the n-type conductivity substrate 10 has better conductivity, thereby resulting in a back contact solar cell with lower sheet resistance and improved efficiency.

Exemplarily, the substrate 10 is an n-type silicon substrate 10. Compared with the p-type conductivity substrate 10, the n-type conductivity substrate 10 has advantages such as high minority carrier lifetime, no light-induced degradation, and good weak light performance.

The first doped layer 11, the second doped layer 121, and the third doped layer 122 are all semiconductor doped layers. In terms of internal arrangement of materials, the first doped layer 11, the second doped layer 121 and the third doped layer 122 may be amorphous, microcrystalline, single-crystal, nanocrystalline, or polycrystalline, etc. In terms of specific materials, the materials of the first doped layer 11, the second doped layer 121, and the third doped layer 122 may be silicon (Si), germanium (Ge), silicon carbide (SiCx), or gallium arsenide (GaAs), etc. In terms of conductivity type, the first doped layer 11, the second doped layer 121 and the third doped layer 122 may be n-type doped layers or p-type doped layers.

In some examples, when the substrate 10 is an n-type substrate 10, the first doped layer 11 may be a p-type doped layer, and the second doped layer 121 and the third doped layer 122 may be n-type doped layers; or, when the substrate 10 is a p-type substrate 10, the first doped layer 11 may be an n-type doped layer, and the second doped layer 121 and the third doped layer 122 may be p-type doped layers.

For example, as shown in FIG. 1, the substrate 10 is an n-type silicon substrate 10, the first doped layer 11 is a boron-doped p-type doped layer, and the second doped layer 121 and the third doped layer 122 are phosphorus-doped n-type doped layers. In this case, since the region heavily doped with phosphorus has a greater solubility for metal impurities, the phosphorus contained within the second doped layer 121 may provide phosphorus gettering to the first doped layer 11, thereby enhancing the efficiency of the solar cell.

In some examples, the second doped layer 121 is a hydrogenated doped layer. In this case, the second doped layer 121 located on the first doped layer 11 not only protects the integrity of the first doped layer 11 during subsequent patterning processes but also provides additional hydrogen to compensate for dangling bonds within the first doped layer 11. This achieves a passivation effect, reducing carrier recombination at the surface of the first doped layer 11 and ensuring the photovoltaic conversion efficiency of the solar cell.

The second doped layer 121 and the third doped layer 122 may be formed in the same process or in different processes.

In some examples, when the second doped layer 121 and the third doped layer 122 are formed in the same process, they may have the same material. For example, the first doped layer 11 may be a doped polycrystalline silicon layer, and the second doped layer 121 and the third doped layer 122 may be doped polycrystalline silicon layers or doped amorphous silicon layers. When the second doped layer 121 and the third doped layer 122 are formed in different processes, they may have different materials. For example, the first doped layer 11 may be a doped polycrystalline silicon layer, the second doped layer 121 may be a hydrogenated doped polycrystalline silicon layer or a hydrogenated doped amorphous silicon layer, and the third doped layer 122 may be a doped polycrystalline silicon layer or a doped amorphous silicon layer. When the second doped layer 121 and the third doped layer 122 are formed in the same process, it saves a process step, thereby saving time and increasing production capacity and efficiency during mass production. Silicon carbide itself has characteristics such as a wide bandgap, high breakdown electric field, and high thermal conductivity, while hydrogenated silicon carbide layers, hydrogenated doped polycrystalline silicon layers, or hydrogenated doped amorphous silicon layers may provide additional passivation effects due to hydrogen, which helps to improve the photovoltaic conversion efficiency of the back contact solar cell.

In some examples, along the direction where the first doped region 101 and the second doped region 102 are arranged in a staggered manner, the width of the first doped region 101 is greater than that of the second doped region 102. The width of the first doped region 101 ranges from 600µm to 2000µm, while the width of the second doped region 102 ranges from 200µm to 1000µm. Consequently, the width of the first doped layer 11 on the first doped region 101 is greater than the width of the third doped layer 122 on the second doped region 102, resulting in a wider range of the formed pn junction, which allows for a larger area for carrier separation, thereby improving the photovoltaic conversion efficiency of the solar cell. Preferably, the width range of the first doped region 101 is between 600µm and 1500µm, and the width range of the second doped region 102 is between 200µm and 800µm.

For example, the width of the first doped region 101 may be 600µm, and the width of the second doped region 102 may be 500µm; or, the width of the first doped region 101 may be 2000µm, and the width of the second doped region 102 may be 200µm; or, the width of the first doped region 101 may be 1400µm, and the width of the second doped region 102 may be 1000µm.

In some examples, along the direction where the first doped region 101 and the second doped region 102 are arranged in the staggered manner, the width range of the third region 103 is from 10µm to 100µm. A too wide third region 103 may waste the effective area of the back contact solar cell and make it difficult to collect effective carriers, thereby reducing the cell performance. By setting the third region 103 between the first doped region 101 and the second doped region 102, the boundary between the first doped region 101 and the second doped region 102 is separated, eliminating the conventional insulation design between the positive electrode and the negative electrode, which can reduce the production process and the spatial complexity. The structure does not have coexisting of the positive and negative poles in the vertical direction, avoiding the occurrence leakage of back contact solar cell, and can improve the reliability performance of the cell in later products, reducing the production process difficulty of the back contact solar cell.

For example, the width of the third region 103 may be 10µm, 100µm, or 60µm.

As some possible implementations, as shown in FIG. 1, the back contact solar cell further includes a first surface passivation layer 13. The first surface passivation layer 13 covers the surface of the second doped layer 121, the third doped layer 122, and the third region 103. At the contact surface between the first surface passivation layer 13 and the second doped layer 121, a first opening 130 is provided. The first electrode 20 is electrically contacted with the second doped layer 121 through the first opening 130. At the contact surface between the first surface passivation layer 13 and the third doped layer 122, a second opening 131 is provided. The second electrode 21 is electrically contacted with the third doped layer 122 through the second opening 131.

Thus, a first surface passivation layer 13 is formed on the outer side of the second doped layer 121, the third doped layer 122, and the third region 103. The first surface passivation layer 13 may passivate the surface of the back contact solar cell, passivate dangling bonds at the second doped layer 121, the third doped layer 122, and the third region 103, reduce the carrier recombination rate at the first surface, and improve the photovoltaic conversion efficiency. Meanwhile, the first surface passivation layer 13 located at the third region 103 also acts to isolate the second doped layer 121 and the third doped layer 122.

In some examples, the material of the first surface passivation layer 13 may be one or more of silicon nitride, silicon oxide, silicon oxynitride, aluminum oxide, silicon carbide, or amorphous silicon.

For instance, the material of the first surface passivation layer 13 may be silicon oxide.

As some possible implementations, as shown in FIG. 1, the back contact solar cell also includes a first interface passivation layer 14, a second interface passivation layer 151, and a third interface passivation layer 152. The first interface passivation layer 14 is located between the substrate 10 and the first doped layer 11. The second interface passivation layer 151 is located between the first doped layer 11 and the second doped layer 121. The third interface passivation layer 152 is located between the substrate 10 and the third doped layer 122. The first interface passivation layer 14, the second interface passivation layer 151, and the third interface passivation layer 152 respectively passivate the interface between the substrate 10 and the first doped layer 11, between the first doped layer 11 and the second doped layer 121, and between the substrate 10 and the third doped layer 122, reducing carrier recombination at the interface and ensuring efficient carrier transport. On the other hand, the interface passivation layers, together with the semiconductor doped layers, form a passivated contact structure, improving the passivation performance of the back contact solar cell and reducing carrier recombination at the interface, thereby enhancing the conversion efficiency of the back contact solar cell.

In some examples, the first interface passivation layer 14, the second interface passivation layer 151, and the third interface passivation layer 152 may be one or more of oxides, nitrides, carbides, or hydrogenated amorphous silicon. Among them, oxides include silicon oxide, silicon oxynitride, aluminum oxide, titanium oxide, hafnium oxide (HfO₂), gallium oxide (Ga₂O₃), tantalum oxide (Ta₂O₅), niobium oxide (Nb₂O₅), and so on; nitrides include silicon nitride, carbon nitride silicon, aluminum nitride, titanium nitride (TiN), titanium carbonitride (TiCN), and so on; carbides include silicon carbide (SiC).

For example, when the first doped layer 11, the second doped layer 121, and the third doped layer 122 are semiconductor doped layers, the first interface passivation layer 14, the second interface passivation layer 151, and the third interface passivation layer 152 may be tunnel oxide layers. The tunnel oxide layer allows majority carriers to tunnel into the semiconductor doped layer while blocking minority carriers, thereby allowing majority carriers to laterally transport within the semiconductor doped layer and be collected by the electrode, reducing carrier recombination, and improving the open-circuit voltage and short-circuit current of the back contact solar cell. At this point, the tunnel oxide layer, together with the semiconductor doped layer, constitutes a tunnel oxide layer passivated contact structure, achieving excellent interface passivation and selective carrier collection, thereby enhancing the photovoltaic conversion efficiency of the back contact solar cell. The first interface passivation layer 14, the second interface passivation layer 151, and the third interface passivation layer 152 may all be silicon oxide interface passivation layers. Compared with amorphous silicon interface passivation layers that crystallize into polycrystalline silicon at high temperatures, silicon oxide interface passivation layers are more resistant to high temperatures.

As some possible implementations, the second surface of the back contact solar cell also includes an anti-reflection layer. The anti-reflection layer may be formed on the second surface passivation layer 18. The anti-reflection layer reduces the reflection of light incident on the second surface, enhances light refraction, increases the utilization of light incident on the second surface, thereby improving the photovoltaic conversion efficiency of the back contact solar cell.

In some examples, the first surface passivation layer 13 and the second surface passivation layer 18 also serve as anti-reflection layers. The passivation layer and the anti-reflection layer may also be stacked to collectively provide anti-reflection effects.

In some examples, the anti-reflection layer may be made of one or more substances such as magnesium fluoride (MgF₂), silicon dioxide (SiO₂), aluminum oxide (Al₂O₃), zinc sulfide (ZnS), silicon nitride (SiN), titanium dioxide (TiO₂), and so on.

For instance, the anti-reflection layer may be an aluminum oxide anti-reflection layer, or it may be a stack of silicon nitride and silicon dioxide layers forming the anti-reflection layer.

As some possible implementations, as shown in FIG. 1, the surface of the third region 103 has a textured structure. No electrodes are set on the third region 103, allowing for texturing treatment of the third region 103 to create a textured structure. The textured structure has good light trapping and anti-reflection effects, enabling light incident on the first surface to be utilized, enhancing light absorption on the first surface of the back contact solar cell, allowing for dualsided light absorption, further utilizing light energy, and improving the power generation efficiency of the back contact solar cell.

As some possible implementations, as shown in FIG. 1, the surface of the first doped region 101 and/or the second doped region 102 is polished.

Based on this, the surfaces of the first doped region 101 and the second doped region 102 may both be polished, allowing light incident from the second surface to pass through and be reflected again by the back contact solar cell, thereby providing another opportunity for the light to be utilized by the back contact solar cell, thus improving the photovoltaic conversion efficiency of the back contact solar cell. Additionally, the polished surface has better flatness, which facilitates the formation of other layers on the polished surface, reduces the generation of interface defects, thereby reducing carrier recombination caused by defects, benefiting the enhancement of the passivation performance of the back contact solar cell, and thus improving the photovoltaic conversion efficiency of the back contact solar cell.

As some possible implementations, as shown in FIG. 1, the second surface has a textured structure. The second surface also has a second surface passivation layer 18. The textured structure on the second surface has good light trapping effects, reducing the reflection of light incident on the second surface, thereby improving the utilization of light. The second surface passivation layer 18 serves to passivate the interface of the substrate 10 on the second surface, reducing carrier recombination at the interface, improving carrier transport efficiency, and thus enhancing the photovoltaic conversion efficiency of the back contact solar cell.

In some examples, the material of the second surface passivation layer 18 may be one or more substances such as silicon nitride, silicon oxide, silicon oxynitride, aluminum oxide, silicon carbide, or amorphous silicon.

As shown in FIG. 2 to FIG. 9, the embodiments of the present application further provide a method for manufacturing a back contact solar cell, including the following steps:
Step S100: providing a substrate 10, the substrate 10 having a first surface and a second surface disposed opposite to each other, the first surface having a first doped region 101,a second doped region 102 and a third region 103, the first doped region 101 and the second doped region 102 are arranged in a staggered manner, the third region 103 is located between the first doped region 101 and the second doped region 102;
Step S200: forming a first doped layer 11 on the first surface of the substrate 10;
Step S300: removing the first doped layer 11 located at the second doped region 102 and the third region 103;
Step S400: forming a doped film layer 12 on the first doped layer 11 and the first surface;
Step S500: removing the doped film layer 12 on the third region 103, so that the doped film layer 12 on the first doped layer 11 becomes a second doped layer 121, and the doped film layer 12 on the first surface becomes a third doped layer 122;
Step S600: forming a first electrode 20 on the second doped layer 121, and forming a second electrode 21 on the third doped layer 122.

Compared with the conventional technology, the advantageous effects of the manufacturing method for the back contact solar cell provided in the embodiments of the present application are the same as those of the back contact solar cell mentioned above, and are not repeated here.

In practical applications, the substrate 10 needs to undergo damage removal treatments such as polishing and cleaning. The thickness ranges of the first doped layer 11, the second doped layer 121, and the third doped layer 122 are all from 50nm to 500nm. The processes for forming the first doped layer 11 on the substrate 10 and forming the doped film layer 12 on the first doped layer 11 and the first surface may be plasma-enhanced chemical vapor deposition (PECVD), hot-wire chemical vapor deposition, physical vapor deposition (PVD), low-pressure chemical vapor deposition (LPCVD), or catalytic chemical vapor deposition processes. The processes for removing the first doped layer 11 located on the second doped region 102 and the third region 103, as well as removing the doped film layer 12 on the third region 103, may be laser etching, ion milling etching, plasma etching, reactive ion etching, alkaline etching, or acid etching processes.

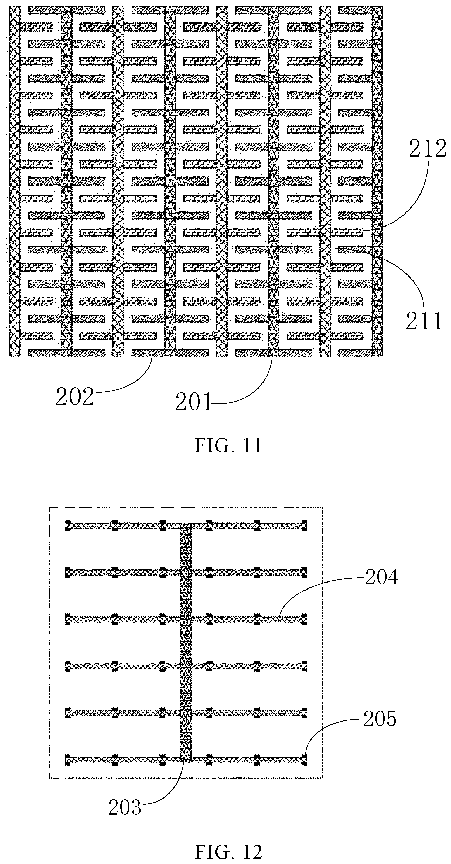

In practical applications, the width ranges of the first electrode 20 and the second electrode 21 are from 5µm to 100µm. The formed first electrode 20 and second electrode 21 may be continuous contact electrodes. In this case, as shown in FIG. 11, the first electrode 20 includes a first electrode main electrode 201 and a first electrode sub-gate line 202, and the second electrode 21 includes a second electrode main electrode 211 and a second electrode sub-gate line 212. Alternatively, the formed first electrode 20 and second electrode 21 may be local contact electrodes. As shown in FIG. 12, taking the first electrode 20 as an example, the first electrode 20 can include a connecting electrode 203 and a fine gate line 204, the fine gate line 204 is connected to the connecting electrode 203 and conducts current through the connecting electrode 203. In this case, the continuous contact electrode does not contact the second doped layer 121, while the fine gate line 204 contacts the second doped layer 121, or only certain areas of the fine gate line 204 contact the second doped layer 121, while the rest do not. Specifically, as shown in FIG. 12, the connecting electrode 203 acts as a current collector, the fine gate line 204 acts as a transmitter, not in contact with the second doped layer 121, and only the local contact point 205 on the fine gate line 204 is in contact with the second doped layer 121. Welding pads or electrode output points may be set on the main electrodes to output the electrical energy of the solar cell. The fine gate line 204 may be prepared using different electrode pastes, such as the fine gate line 204 composed of a first type of conductive paste and a second type of conductive paste after metal heat treatment, where the first type of conductive paste has the characteristic of penetrating the dielectric membrane, the second type of conductive paste does not have the characteristic of penetrating the dielectric membrane, the first type of conductive paste is intermittently distributed, and the second type of conductive paste partially or completely covers the first type of conductive paste, with areas of the first type of conductive paste being interconnected.

In practical applications, the processes for forming the first electrode 20 and the second electrode 21 may include electrodeposition, transfer printing processes (such as laser transfer printing, heat transfer printing, etc.), screen printing, physical vapor deposition of metals, or processes for metal oxide electrodes. Various processes may also be combined, for example, this may be achieved by first printing electrodes to form power supply points, then applying electrodeposition processes at the power supply points to form the final first electrode 20 and second electrode 21; or by using metal oxide deposition in the gas phase, such as transparent conductive oxides (TCOs), and then forming the first electrode 20 and the second electrode 21 through screen printing or transfer printing, and so on.

In some examples, the methods for forming the first doped layer 11 and the doped film layer 12 may be in-situ doping methods or non-in-situ doping methods. That is, the first doped layer 11 and the doped film layer 12 may be directly formed, or intrinsic semiconductor layers and intrinsic semiconductor film layers may be formed first, followed by doping to form the first doped layer 11 and the doped film layer 12, respectively.

Taking the manufacturing method of the n-type back contact solar cell shown in FIG. 1 as an example, the specific steps are described as follows:
As shown in FIG. 2, a silicon substrate 10 with n-type doping is provided, and then the silicon substrate 10 undergoes damage removal treatments such as polishing and cleaning sequentially.

A boron-doped p-type polycrystalline silicon layer is deposited on the first surface of the n-type silicon substrate 10 using a PECVD device.

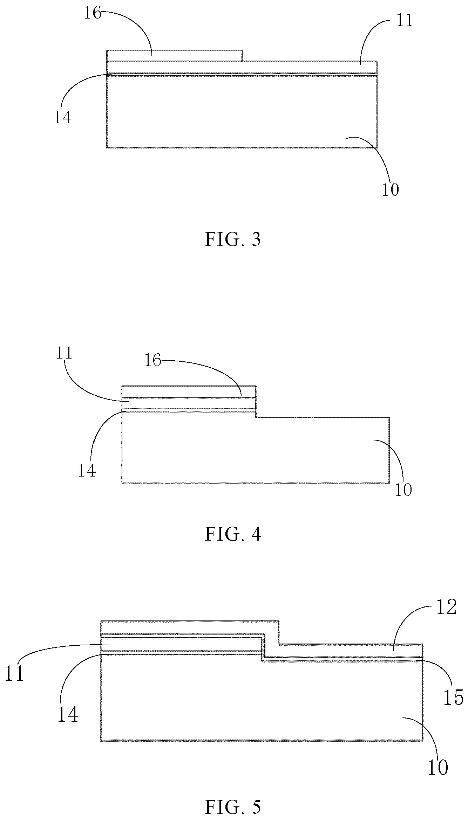

As shown in FIG. 3, an alkaline etching process is used to remove the boron-doped p-type polycrystalline silicon layer located on the second doped region 102 and the third region 103, forming the first doped layer 11 with a thickness of 200nm.

As shown in FIG. 5, a phosphorus-doped n-type polycrystalline silicon layer is deposited on the first doped layer 11 and the first surface using a PECVD device to form the doped film layer 12.

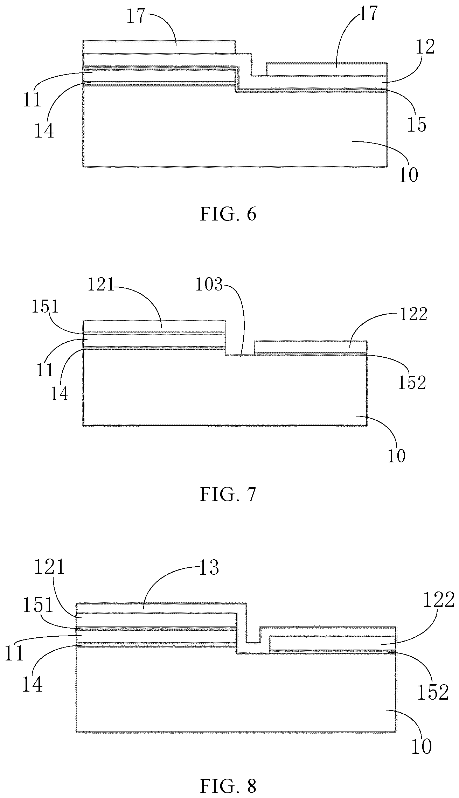

As shown in FIG. 7, an alkaline etching process is used to remove the doped film layer 12 located on the third region 103, so that the doped film layer 12 on the first doped layer 11 becomes the second doped layer 121, and the doped film layer 12 on the first surface becomes the third doped layer 122. The radii of curvature of the second doped layer 121 and the third doped layer 122 are both 200nm.

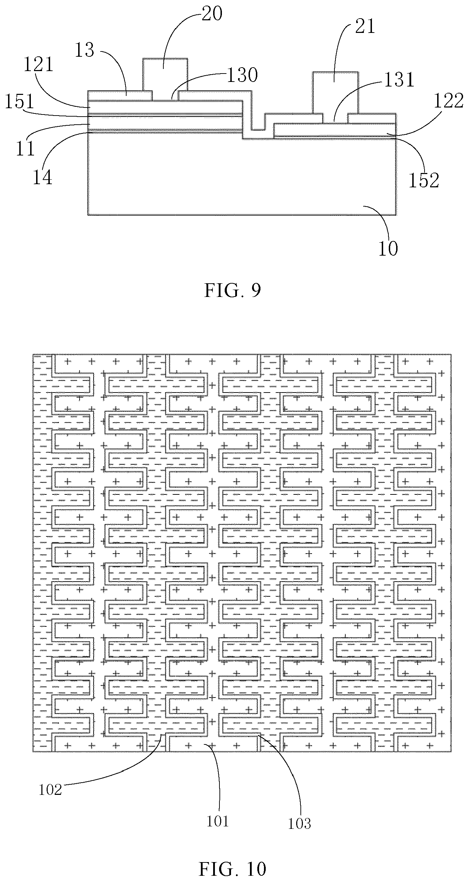

As shown in FIG. 9, a screen printing process is used to form the first electrode 20 on the second doped layer 121, and the second electrode 21 is formed on the third doped layer 122. Both the first electrode 20 and the second electrode 21 are local contact electrodes with a width of 50µm.

As some possible implementation methods, as shown in FIG. 3 to FIG. 5, the removal of the first doped layer 11 located in the second doped region 102 and the third region 103 is specifically performed as follows: a first protecting layer 16 is formed on the first doped layer 11 on the first doped region 101; then the first doped layer 11 on the second doped region 102 and the third region 103 is removed; finally, the first protecting layer 16 is removed. Based on this, during subsequent graphical and cleaning processes, the first protecting layer 16 may protect the first doped layer 11, preventing it from being corroded or damaged. Since the first protecting layer 16 may contain metal ions or other impurities, it is removed after it is no longer needed to ensure better passivation of the back contact solar cell in subsequent processes.

In some examples, the first protecting layer 16 at least includes one of a dielectric layer and a mask layer. The used dielectric layer and/or mask layer have significant differences in physical or chemical properties compared to the first doped layer 11 to ensure that during etching or corrosion processes to remove the first doped layer 11 located in the second doped region 102 and the third region 103, the first protecting layer 16 may be effectively retained. The process for forming the first protecting layer 16 may employ techniques such as plasma-enhanced chemical vapor deposition (PECVD), atmospheric pressure chemical vapor deposition (APCVD), and thermal growth processes. Methods for removing the first protecting layer 16 can include acid washing, alkaline washing, and water washing.

For example, when using an alkaline etching process, a medium layer that does not react with the alkali used may be selected as the first protecting layer 16, while the first doped layer 11 reacts with the selected alkali. Based on this, during the graphical treatment of the first doped layer 11, the first doped layer 11 located on the second doped region 102 and the third region 103 is removed, while the first doped layer 11 covered by the first protecting layer 16 is completely preserved. Examples of materials for the dielectric layer include silicon oxide, silicon nitride, or silicon carbide (SiCx). When oxide is chosen as the dielectric layer, a thermal growth process may be used to form the dielectric layer, whereby an oxide layer is formed on the surface of the first doped layer 11 in an oxidizing atmosphere (such as air or oxygen) using heating methods.

For instance, silicon oxide may be chosen as the dielectric layer for the first protecting layer 16. In this case, the thickness of the first protecting layer 16 is in the range of 20nm to 100nm.

Furthermore, when using a laser etching process, a mask layer resistant to laser ablation may be selected as the first protecting layer 16, whereas the first doped layer 11 may be ablated by the laser. In this case, the mask layer used may be photolithographically patterned, printable resin masking, silicon nitride (SiNx), silicon oxide (SiOx), or silicon carbide (SiC), among others.

Moreover, when the first protecting layer 16 is a stack of dielectric and mask layers, preferably, the dielectric layer shall be close to the first doped layer 11 to ensure the passivation effect of the first doped layer 11, while the mask layer, due to its higher impurity content, should be kept away from the first doped layer 11 to prevent contamination.

For example, as shown in FIG. 3 to FIG. 5, to remove the first doped layer 11 located in the second doped region 102 and the third region 103, the following steps may be performed: depositing silicon oxide as the first protecting layer 16 on the p-type polycrystalline silicon layer using the PECVD process; then removing the p-type polycrystalline silicon layer on the second doped region 102 and the third region 103 using an alkaline etching process; finally, washing away the removed first protecting layer 16 with a solution containing hydrofluoric acid (HF).

Additionally, when the first protecting layer 16 is silicon oxide and the first doped layer 11 is a boron-doped p-type polycrystalline silicon layer, the first protecting layer 16 and the first doped layer 11 may be formed in a single step. For instance, after forming an intrinsic polycrystalline silicon layer, a thermal diffusion process may be used by introducing gases such as BCl₃ or BBr₃ (which inevitably contain oxygen during the thermal diffusion process) under heating conditions to dope the intrinsic polycrystalline silicon layer, thereby forming the p-type polycrystalline silicon layer, while an oxide layer is formed on the surface of the p-type polycrystalline silicon layer.

When the substrate 10 is a p-type silicon substrate 10, the thermal diffusion process may be replaced with a phosphorus doping process. In this case, the in-situ doped p-type polycrystalline silicon layer may also be replaced with an n-type polycrystalline silicon layer. The POCl₃ used in the thermal diffusion process can similarly form a phosphorus-doped n-type polycrystalline silicon layer and an oxide layer on top of it.

Moreover, when removing the stack structure of the first protecting layer 16 with silicon oxide, the mask layer may be patterned first, and then the first surface of the back contact solar cell may be cleaned using a solution containing hydrofluoric acid (HF) to remove the silicon oxide from areas where no masking material is applied.

As some possible implementations, as shown in FIG. 5 to FIG. 7, to the step of removing the doped film layer 12 located on the third region 103, specifically is: forming a second protecting layer 17 on the doped film layer 12 located on the first doped region 101 and the second doped region 102; removing the doped film layer 12 located on the third region 103; removing the second protecting layer 17. The material selection, process treatment methods, and implementation examples of the second protecting layer 17 are the same as those of the first protecting layer 16. The second protecting layer 17 is used to protect the second doped layer 121 and the third doped layer 122, ensuring that they are not corroded or damaged in subsequent cleaning or etching processes. Since the second protecting layer 17 may contain metal ions or other contaminants, it is removed after it is no longer needed to ensure better passivation of the back contact solar cell in subsequent processes.

In some examples, the second protecting layer 17 includes a mask layer. Preferably, the mask layer is a layer of silicon nitride (SiNx), silicon oxide (SiOx), or silicon carbide (SiC) deposited using the PECVD process.

For example, as shown in FIG. 5 to FIG. 7, the step of removing the doped film layer 12 located on the third region 103, specifically is: depositing silicon oxide as the second protecting layer 17 on the n-type polycrystalline silicon layer located in the first doped region 101 and the second doped region 102 using the PECVD process; adopting an alkaline etching process to remove the n-type polycrystalline silicon layer located on the third region 103; removing the second protecting layer 17 using laser ablation.

As some possible implementations, as shown in FIG. 2 to FIG. 7, before forming the first doped layer 11 on the first surface of the substrate 10, the following steps are included: forming a first interface passivation layer 14 on the first surface of the substrate 10. In the step of removing the first doped layer 11 located in the second doped region 102 and the third region 103, the following step is included: removing the first interface passivation layer 14 located in the second doped region 102 and the third region 103. The process for forming the first interface passivation layer 14 may include techniques such as plasma-enhanced chemical vapor deposition (PECVD), atmospheric pressure chemical vapor deposition (APCVD), and thermal growth processes. The process for removing the first interface passivation layer 14 may include techniques such as laser etching, ion milling etching, plasma etching, reactive ion etching, alkaline etching, and acid etching.

In some examples, the first interface passivation layer 14 may be a tunneling oxide layer, and the thickness range of the tunneling oxide layer is from 0.5nm to 5nm.

For example, as shown in FIG. 2 to FIG. 7, before forming the first doped layer 11 on the first surface of the substrate 10, the following steps are included: depositing a silicon oxide tunneling oxide layer as the first interface passivation layer 14 on the first surface of the n-type silicon substrate 10 using the PECVD process. In the step of removing the first doped layer 11 located on the second doped region 102 and the third region 103, the following step is included: using an alkaline etching process to remove the first interface passivation layer 14 located on the second doped region 102 and the third region 103.

Additionally, when the first interface passivation layer 14 is a tunneling oxide layer and the first doped layer 11 is a boron-doped p-type polycrystalline silicon layer, the first interface passivation layer 14 and the first doped layer 11 may be formed in a single step, that is, directly growing the tunneling oxide layer and boron-doped p-type polycrystalline silicon layer.

As some possible implementations, as shown in FIG. 5 to FIG. 7, after removing the first interface passivation layer 14 and the first doped layer 11 located on the second doped region 102 and the third region 103, and before forming the doped film layer 12 on the first doped layer 11 and the first surface, the following steps are included: forming an interface passivation film layer 15 on the first doped layer 11 and the first surface. In the step of removing the doped film layer 12 located on the third region 103, the following step is included: removing the interface passivation film layer 15 located on the third region 103, such that the interface passivation film layer 15 on the first doped layer 11 becomes the second interface passivation layer 151, and the interface passivation film layer 15 on the first surface becomes the third interface passivation layer 152. The process for forming the interface passivation layer may include techniques such as plasma-enhanced chemical vapor deposition (PECVD), atmospheric pressure chemical vapor deposition (APCVD), and thermal growth processes. The process for removing the interface passivation film layer can include techniques such as laser etching, ion milling etching, plasma etching, reactive ion etching, alkaline etching, and acid etching.

In some examples, the first interface passivation layer 14 may be a tunneling oxide layer, with a thickness ranging from 1nm to 2nm.

For instance, as illustrated in FIG. 5 to FIG. 7, after removing the first interface passivation layer 14 and the first doped layer 11 located on the second doped region 102 and the third region 103, and before forming the doped film layer 12 on the first doped layer 11 and the first surface, the following steps are included: depositing a silicon oxide tunneling oxide layer as the interface passivation film layer 15 on the p-type polycrystalline silicon layer and the first surface using the PECVD process. In the step of removing the doped film layer 12 located on the third region 103, the following step is included: using an alkaline etching process to remove the interface passivation film layer 15 located on the third region 103, such that the interface passivation film layer 15 on the first doped layer 11 becomes the second interface passivation layer 151, and the interface passivation film layer 15 on the first surface becomes the third interface passivation layer 152.

Additionally, when the interface passivation film layer 15 is a tunneling oxide layer and the doped film layer 12 is a phosphorus-doped n-type polycrystalline silicon layer, the interface passivation film layer 15 and the doped film layer 12 may be formed in a single step, directly growing the tunneling oxide layer and the phosphorus-doped n-type polycrystalline silicon layer.

As some possible implementations, after removing the doped film layer 12 located on the third region 103, the following step is included: performing texture treatment on the third region 103.

Preferably, the texture treatment of the third region 103 and the removal of the doped film layer 12 located on the third region 103 are completed in the same step. For example, when using alkaline etching to remove the doped film layer 12 located on the third region 103, a velvety structure may be formed on the third region 103 at the same time.

As some possible implementations, as shown in FIG. 7 to FIG. 9, the step of forming the first electrode 20 on the second doped layer 121 and the second electrode 21 on the third doped layer 122, specifically is: forming a first surface passivation layer 13 on the second doped layer 121, the third doped layer 122, and the third region 103; forming the first electrode 20 on the first surface passivation layer 13 on the second doped layer 121, and forming the second electrode 21 on the first surface passivation layer 13 on the third doped layer 122, where the first electrode 20 is electrically contacted with the second doped layer 121, and the second electrode 21 electrically contact the third doped layer 122.

In practical applications, the formation process of the first surface passivation layer 13 may include techniques such as plasma-enhanced chemical vapor deposition (PECVD), hot-wire chemical vapor deposition, physical vapor deposition (PVD), low-pressure chemical vapor deposition (LPCVD), or catalytic chemical vapor deposition, among others. When the back contact solar cell has the first surface passivation layer 13, and the first electrode 20 and the second electrode 21 are continuous contact electrodes, the method of forming the first electrode 20 and the second electrode 21 may involve coating electrode paste onto the first surface passivation layer 13, followed by sintering, allowing the electrode paste to penetrate through the first surface passivation layer and are electrically contacted with the second doped layer 121 and the third doped layer 122, respectively. When the back contact solar cell has the first surface passivation layer 13, and the first electrode 20 and the second electrode 21 are local contact electrodes, the method of forming the first electrode 20 and the second electrode 21 may involve first creating the first opening 130 and the second opening 131 in the first surface passivation layer 13, then using methods such as printing paste, laser transfer printing, electroplating, chemical plating, photolithographic electroplating, or vacuum deposition, magnetron sputtering, etc., to form local contact first electrode 20 and second electrode 21. The method for forming the openings may include laser ablation or using etching paste that can react with the first surface passivation layer 13. The method of making electrical contact through openings allows the back contact solar cell to achieve lower metal region recombination, ensuring high conversion efficiency of the back contact solar cell. Obviously, a combination of one or more of the aforementioned methods may also be used to form the first electrode 20 and the second electrode 21. For example, using a combination of physical vapor deposition (PVD) seed layer with printed electrodes, or screen printing electrode paste combined with electroplating, or a combination of laser transfer printing method and screen printing sintering method, etc.

As exemplified in FIG. 7 to FIG. 9, to form the first electrode 20 on the second doped layer 121 and the second electrode 21 on the third doped layer 122, specifically is: depositing a layer of silicon nitride using the PECVD process as the first surface passivation layer 13 on the second doped layer 121, the third doped layer 122, and the third region 103; using laser ablation to open the first opening 130 on the first surface passivation layer 13 on the second doped layer 121, then using the method of printing conductive paste to form the first electrode 20; using laser ablation to open the second opening 131 on the first surface passivation layer 13 on the third doped layer 122, then using the method of printing conductive paste to form the second electrode 21, where the first electrode 20 is electrically contacted with the second doped layer 121 through the first opening 130, and the second electrode 21 is electrically contacted with the third doped layer 122 through the second opening 131.

As shown in FIG. 8 to FIG. 10, when the substrate 10 is an n-type silicon substrate 10 and the first doped layer 11 is a p-type polycrystalline silicon layer, under the electrode formation method by filming mentioned above, a p-type contact region is formed in the first region, which is not directly in contact with the first doped layer 11, but directly contacts the second doped layer 121 on the first region through the first opening 130. Through carrier tunneling, the first polarity carriers in the first region tunnel through the first doped layer 11 into the second doped layer 121 and are collected through the first electrode 20 on the second doped layer 121. An n-type contact region is formed in the second region, where the second polarity carriers in the second region tunnel through the third doped layer 122 into the third doped layer 122 and are collected through the second electrode 21 on the third doped layer 122. Afterwards, conductive paste may be printed and sintered on the first surface passivation layer 13 to form metallized contacts, forming a p-type metal region in the p-type contact region and an n-type metal region in the n-type contact region. Alternatively, conductive paste may be directly printed and sintered on the first surface passivation layer 13 to form corresponding p-type metal regions and n-type metal regions. Finally, the first electrode 20 and the second electrode 21 are formed.

Exemplarily, after forming the first electrode 20 and the second electrode 21, there may be additional steps. For example, processes such as optical injection, electrical injection of carriers, or other heat treatments, as well as efficiency sorting or slicing steps.

In some examples, the step of forming the third region 103 may be set before the formation of the first surface passivation layer 13. The step of forming the third region 103 may also be set after the preparation of the outer back contact solar cell, but this may sacrifice some passivation of the third region 103.

As a possible implementation, before forming the first surface passivation layer 13 on the second doped layer 121, the third doped layer 122, and the third region 103, there may be a step of performing a heat treatment process. The heat treatment process crystallizes at least a portion of the first doped layer 11 and/or the second doped layer 121 and/or the third doped layer 122. Heat treatment may be applied to p-type or n-type semiconductor layers to further distribute dopants or change the structure of semiconductor layers, which is more conducive to improving cell performance. For example, when the first doped layer 11, the second doped layer 121, and the third doped layer 122 are amorphous or microcrystalline semiconductors, annealing may crystallize at least a portion of the first doped layer 11 and/or the second doped layer 121 and/or the third doped layer 122, thereby improving the conductivity of the first doped layer 11, the second doped layer 121 and the third doped layer 122. In addition, annealing can make the tunnel oxide layer more conducive to selective carrier transmission; heating can also allow dopants to enter the tunnel oxide layer and the substrate 10, thereby reducing transmission resistance.

As a possible implementation, there can also be a step of texturing the second surface and forming a second surface passivation layer 18 on the second surface. The process of forming the second surface passivation layer 18 may include techniques such as plasma-enhanced chemical vapor deposition (PECVD), hot-wire chemical vapor deposition, physical vapor deposition (PVD), low-pressure chemical vapor deposition (LPCVD), or catalytic chemical vapor deposition. Preferably, the graphical treatment of the third region 103 and the texturing treatment of the second surface may be completed in the same step, reducing one or more production steps and greatly increasing commercial production capacity.

In some examples, the step of texturing the second surface may be performed after the formation of the second doped layer 121 and the third doped layer 122. In the conventional technology, the step of texturing the second surface is usually performed before the formation of the first doped layer 11 on the first surface, making it easy to damage the textured surface on the second surface during the removal or cleaning process of the first doped layer 11, the second doped layer 121 or the third doped layer 122. The process of texturing the second surface in the embodiments of the present application is placed after the formation of the second doped layer 121 and the third doped layer 122, ensuring the integrity of the textured structure and its excellent light-trapping performance. Especially when the textured structure on the second surface is a nanostructured surface, various cleaning processes and etching processes almost inevitably damage the nanostructured textured structure. In recent years, nanostructured textures on the light-receiving surface have been increasingly widely used, making the advantages of post-texturing more prominent. Nanostructured textured structures have better light-trapping effects, and since the light-receiving surface of the back contact solar cell does not have electrodes, the color of the second surface will be more beautiful after applying nanostructured textured structures on the back contact solar cell. Therefore, nanostructured textured structures are more suitable for back contact solar cells.

In some examples, the step of forming the second surface passivation layer 18 may be performed at the same time with the step of forming the first surface passivation layer 13.

In some examples, after forming the second surface passivation layer 18, a layer of anti-reflection coating may be formed on the second surface passivation layer 18.

In the description of the above embodiments, specific features, structures, materials, or characteristics may be combined in any suitable manner in any one or more embodiments or examples.

The above are merely particular embodiments of the present disclosure, but the protection scope of the present disclosure is not limited thereto. All of the variations or substitutions that a person skilled in the art can easily envisage within the technical scope disclosed by the present disclosure should fall within the protection scope of the present disclosure. Therefore, the protection scope of the present disclosure should be subject to the protection scope of the claims.

## Claims

1. A back contact solar cell, comprising:
a substrate comprising a first surface and a second surface opposite to each other, wherein the first surface comprises a first doped region, a second doped region and a third region, the first doped region and the second doped region are arranged in a staggered manner, and the third region is located between the first doped region and the second doped region;
a first doped layer and a second doped layer sequentially formed on the first doped region, wherein a conductivity type of the first doped layer is opposite to a conductivity type of the second doped layer;
a third doped layer formed on the second doped region, wherein a conductivity type of the third doped layer is opposite to the conductivity type of the first doped layer; and
a first electrode and a second electrode, wherein the first electrode is electrically contacted with the second doped layer, and the second electrode is electrically contacted with the third doped layer.

2. The back contact solar cell according to claim 1, wherein along a staggering direction of the first doped region and the second doped region, a width of the third region is 10µm~100µm; and/or a surface of the third region has a velvety structure.

3. The back contact solar cell according to claim 1, wherein a surface of the first doped region and/or a surface of the second doped region is a polished surface.

4. The back contact solar cell according to claim 1, wherein the second doped layer is a hydrogen-doped layer.

5. The back contact solar cell according to claim 1, wherein the first doped layer is a doped polycrystalline silicon layer, and the second doped layer and the third doped layer are doped polycrystalline silicon layers or doped amorphous silicon layers; or
the first doped layer is a doped polycrystalline silicon layer, the second doped layer is a hydrogen-doped polycrystalline silicon layer or a hydrogen-doped amorphous silicon layer, and the third doped layer is a doped polycrystalline silicon layer or a doped amorphous silicon layer; or
the first doped layer is a doped polycrystalline silicon layer, the second doped layer is a hydrogen-doped doped silicon carbide layer, and the third doped layer is a doped polycrystalline silicon layer or a doped amorphous silicon layer.

6. The back contact solar cell according to claim 1, wherein the back contact solar cell further comprises a first interface passivation layer, a second interface passivation layer and a third interface passivation layer, wherein the first interface passivation layer is located between the substrate and the first doped layer, the second interface passivation layer is located between the first doped layer and the second doped layer, and the third interface passivation layer is located between the substrate and the third doped layer.

7. The back contact solar cell according to claim 1, wherein the substrate is an n-type substrate, the first doped layer is a p-type doped layer, and the second doped layer and the third doped layer are n-type doped layers; or,
the substrate is a p-type substrate, the first doped layer is an n-type doped layer, and the second doped layer and the third doped layer are p-type doped layers.

8. The back contact solar cell according to claim 7, wherein, along a staggering direction of the first doped region and the second doped region, a width of the first doped region is greater than a width of the second doped region, the width of the first doped region is 600µm~2000µm, and the width of the second doped region is 200µm~1000µm.

9. The back contact solar cell according to claim 1, wherein the back contact solar cell further comprises a first surface passivation layer, wherein the first surface passivation layer covers the second doped layer, the third doped layer, and the third region;
the first surface passivation layer has a first opening at a contact surface with the second doped layer, the first electrode is electrically contacted with the second doped layer via the first opening; the first surface passivation layer has a second opening at the contact surface with the third doped layer, the second electrode is electrically contacted with the third doped layer via the second opening.

10. A method for manufacturing the back contact solar cell according to any one of claims 1 to 9, wherein the method comprises:
providing the substrate having the first surface and the second surface opposite to each other, wherein the first surface has the first doped region, the second doped region and the third region, the first doped region and the second doped region are arranged in the staggered manner, and the third region is located between the first doped region and the second doped region;
forming the first doped layer on the first surface of the substrate;
removing the first doped layer located on the second doped region and the third region;
forming the doped film layer on the first doped layer and the first surface;
removing the doped film layer on the third region, to regard the doped film layer on the first doped layer as the second doped layer, and the doped film layer on the first surface as the third doped layer;
forming the first electrode on the second doped layer, and forming the second electrode on the third doped layer.

11. The method for manufacturing the back contact solar cell according to claim 10, wherein the step of removing the first doped layer located on the second doped region and the third region comprises:
forming a first protecting layer on the first doped layer in the first doped region;
removing the first doped layer on the second doped region and the third region;
removing the first protecting layer; and/or,
the step of removing the doped film layer on the third region comprises:
forming a second protecting layer on the doped film layer of the first doped region and the second doped region;
removing the doped film layer on the third region;
removing the second protecting layer.

12. The method for manufacturing the back contact solar cell according to claim 11, wherein the first protecting layer and the second protecting layer comprise at least one of a dielectric layer and a mask layer.

13. The method for manufacturing the back contact solar cell according to claim 10, wherein a method for forming the first doped layer and the doped film layer is an in-situ doping method or a non-in-situ doping method.

14. The method for manufacturing the back contact solar cell according to claim 10, wherein, before forming the first doped layer on the first surface of the substrate, the method further comprises: forming a first interface passivation layer on the first surface of the substrate;
in the step of removing the first doped layer of the second doped region and the third region, the method further comprises: removing the first interface passivation layer of the second doped region and the third region; and/or,
after removing the first interface passivation layer and the first doped layer of the second doped region and the third region, and before forming the doped film layer on the first doped layer and the first surface, the method further comprises: forming an interface passivation film layer on the first doped layer and the first surface;
in the step of removing the doped film layer on the third region, the method further comprises: removing the interface passivation film layer on the third region, to regard the interface passivation film layer on the first doped layer as the second interface passivation layer, and regard the interface passivation film layer on the first surface as the third interface passivation layer.

15. The method for manufacturing the back contact solar cell according to claim 10, wherein, after removing the doped film layer on the third region, the method further comprises: texturing the third region.

16. The method for manufacturing the back contact solar cell according to claim 10, wherein, the step of forming the first electrode on the second doped layer and forming the second electrode on the third doped layer comprises:
forming a first surface passivation layer on the second doped layer, the third doped layer, and the third region;
forming the first electrode on the first surface passivation layer located at the second doped layer, and forming the second electrode on the first surface passivation layer located at the third doped layer, wherein the first electrode is electrically contacted with the second doped layer, and the second electrode is electrically contacted with the third doped layer.

17. The method for manufacturing the back contact solar cell according to claim 16, wherein, before forming the first surface passivation layer on the second doped layer, the third doped layer, and the third region, the method further comprises: conducting a heat treatment process, wherein the heat treatment process crystallizes at least a portion of the first doped layer and/or the second doped layer and/or the third doped layer.
